# EUROPEAN PATENT APPLICATION

(11) **EP 4 708 597 A1**
(43) Date of publication of application: **11.03.2026**
(21) Application number: 25196717.0
(22) Date of filing: 19.08.2025
(51) Int. Cl.: H02G 3/12, H02G 3/18

(54) **APPARATUS AND METHOD FOR MOUNTING OF POWER, SWITCH OR DATA MODULES**

(30) Priority: 19.08.2024 AU 2024205863
(71) Applicant: ZETR PTY LTD, Mona Vale, NSW 2103 (AU)
(72) Inventor: ROMANO, Joseph, New South Wales, 2103 (AU)
(74) Representative: HGF

(57) **Abstract**

Apparatus 300, 300' comprises a flange 302 configured for abutment against and anchorage to the planar supporting surface 402. An operatively front face 302a of the flange 302 defines a first major surface of the flange, and has an outer periphery and an inner periphery. An operatively rear face 302b of the flange 302 defines a second major surface of the flange, and has an outer periphery and an inner periphery. An outer rim 302c of the flange extends between the outer periphery of the operatively front face 302a and the outer periphery of the operatively rear face 302b. An inner rim of the flange 302 extends between the inner periphery of the operatively front face 302a and the inner periphery of the operatively rear face 302b, and defines an opening 304 extending through the flange. A mounting socket 306 for a power, switch or data module 200 is connected to the flange 302 in alignment with and extending rearwardly from the opening 304. The mounting socket 306 receives, via the opening 304, and mounts relative to the flange 302, the power, switch or data module 200. The flange 302 is reconfigurable via at least one line of weakness 308 in the flange.

## Description

### Technical Field

The disclosure herein relates to an apparatus and method for mounting of power, switch or data modules.

### Background

Indoor electrical modules are usually mounted at a location that is easily accessed by users, and are usually also visible. Therefore, they can influence the aesthetic appearance of the indoor space in which they are located.

Electrical modules often have a trim that can be aesthetically unappealing, as the trim protrudes outwardly from the indoor surface on which the electrical module is located. Trimless electrical modules, on the other hand, can be recessed into the indoor surface on which they are located to provide a flush finish. Whilst usually more aesthetically pleasing than trimmed electrical modules, trimless modules can be laborious to install, including due to often requiring accurate positioning during installation to achieve a flush finish with the indoor surface on which the module is located. Also, any post-installation work, such as re-rendering of the indoor surface, can compromise the original flush finish.

The presence of obstacles, such as elements of wall frames and plumbing behind the interior surface on which an electrical module is to be located can restrict the locations at which it is possible to locate the electrical module and can make installation of the electrical module more difficult.

Any discussion of documents, acts, materials, devices, articles or the like which has been included in the present specification is not to be taken as an admission that any or all of these matters form part of the prior art base or were common general knowledge in the field relevant to the present disclosure as it existed before the priority date of each of the appended claims.

### Summary

Disclosed herein is an apparatus for mounting a power, switch or data module, the apparatus comprising:
a flange configured for abutment against and anchorage to a planar supporting surface of a substrate, the flange having:
   an operatively front face defining a first major surface of the flange, and having an outer periphery and an inner periphery,
   an operatively rear face defining a second major surface of the flange, and having an outer periphery and an inner periphery,
   an outer rim extending between the outer periphery of the operatively front face and the outer periphery of the operatively rear face, and
   an inner rim extending between the inner periphery of the operatively front face and the inner periphery of the operatively rear face, the inner rim defining an opening extending through the flange,
the flange having connected thereto, or being configured to have connected thereto, a mounting socket for a power, switch or data module, the mounting socket, when connected to the flange, being aligned with and extending at least rearwardly from the opening to receive, and mount relative to the flange, a said power, switch or data module inserted through the opening,
wherein the flange is reconfigurable via at least one line of weakness in the flange.

The at least one line of weakness may be configured to facilitate one or more of: removing a portion of the flange outboard of the at least one line of weakness; and folding of the flange about each of one or more fold line defined by a said line of weakness to reorient a portion of the flange outboard of the fold line relative to a portion of the flange inboard thereof. At least some of the at least one line of weakness may be frangible so as to facilitate tearing of the flange therealong. At least some of the at least one line of weakness may be a reduced thickness portion of the flange so as to facilitate cutting or folding of the flange therealong. With increasing distance from the opening, the flange may taper in thickness toward at least some of the at least one line of weakness that is/are configured to facilitate removing the portion of the flange outboard thereof. The at least one line of weakness configured to facilitate folding of the flange thereabout may comprise a plurality thereof that is perpendicular to each other and/or a plurality thereof that is parallel to each other. The at least one line of weakness configured to facilitate folding of the flange thereabout may be orientated relative to one another such as to facilitate the flange being tessellated. The at least one line of weakness configured to facilitate removing a portion of the flange outboard thereof may comprise at least one said line of weakness that is parallel or substantially parallel to its most closely adjacent portion of the outer rim.

The opening may be circular. Slot portions of a bayonet coupling may be associated with the opening and engageable, upon a said power, switch or data module being inserted through the opening and rotated in the opening, by projecting portions of the bayonet coupling that project from the power, switch or data module. The bayonet coupling may be configured to mount the power, switch or data module relative to the flange in any one of a plurality of predetermined rotational orientations. The plurality of predetermined rotational orientations may comprise at least four equally spaced rotational orientations (e.g., first orientation, second orientation at 90 degrees to the first orientation, third orientation at 180 degrees to the first orientation, and fourth orientation at 270 degrees to the first orientation). A clip may be engageable between the power, switch or data module and the apparatus to lock the module and flange against relative rotation when the module is mounted to the flange. The flange may be secured to the module and one or more projection of the clip may engage a corresponding one or more recess of the apparatus to lock the module and flange against relative rotation when the module is mounted to the flange.

Each of at least some of the at least one line of weakness may be parallel or substantially parallel to its most closely adjacent portion of the outer rim. Each of a plurality of the at least one line of weakness may be perpendicular to each other and/or each of a plurality of the at least one line of weakness may be parallel to each other.

The flange may have a plurality of apertures extending therethrough and/or the operatively front face of the flange may be textured to facilitate retention of a render layer applied thereto.

The socket may be connected to the flange via the opening. The socket may be slidably engageable in the opening to facilitate adjustment of its insertion depth in the opening and may be releasably securable in the opening at the desired insertion depth. The desired insertion depth may include a depth at which an inlet end of the socket extends a first predetermined distance forwardly from the operatively front face of the flange. The first predetermined distance may be equal to a thickness of the substrate, such that, with the operatively front face of the flange in register with a said planar supporting surface on a rear of the substrate, the inlet end of the socket is flush with a front surface of the substrate. Instead or in addition, for example to configure the apparatus for use in embodiments in which the operatively rear surface of the flange is to be in register with a front surface of the substrate, the desired insertion depth may include a depth at which an inlet end of the socket extends a second predetermined distance rearwardly from the operatively front face of the flange.

Also disclosed herein is an assembly, comprising:
a power, switch or data module; and
an apparatus for mounting the power, switch or data module to a planar supporting surface, the apparatus comprising:
   a flange configured for abutment against and anchorage to the planar supporting surface, the flange having:
      an operatively front face defining a first major surface of the flange, and having an outer periphery and an inner periphery,
      an operatively rear face defining a second major surface of the flange, and having an outer periphery and an inner periphery,
      an outer rim extending between the outer periphery of the operatively front face and the outer periphery of the operatively rear face, and
      an inner rim extending between the inner periphery of the operatively front face and the inner periphery of the operatively rear face, the inner rim defining an opening extending through the flange,
   the flange having connected thereto, or being configured to have connected thereto, a mounting socket for the power, switch or data module, the mounting socket, when connected to the flange, being aligned with and extending at least rearwardly from the opening to receive via the opening, and mount relative to the flange, the power, switch or data module,
wherein the flange is reconfigurable via at least one line of weakness in the flange.

The at least one line of weakness may be configured to facilitate one or more of: removing a portion of the flange outboard of the at least one line of weakness; and folding of the flange about each of one or more fold line defined by a said line of weakness to reorient a portion of the flange outboard of the fold line relative to a portion of the flange inboard thereof. At least some of the at least one line of weakness may be frangible so as to facilitate tearing of the flange therealong. At least some of the at least one line of weakness may be a reduced thickness portion of the flange so as to facilitate cutting or folding of the flange therealong. With increasing distance from the opening, the flange may taper in thickness toward at least some of the at least one line of weakness that is/are configured to facilitate removing the portion of the flange outboard thereof. The at least one line of weakness configured to facilitate folding of the flange thereabout may comprise a plurality thereof that is perpendicular to each other and/or a plurality thereof that is parallel to each other. The at least one line of weakness configured to facilitate folding of the flange thereabout may be orientated relative to one another such as to facilitate the flange being tessellated. The at least one line of weakness configured to facilitate removing a portion of the flange outboard thereof may comprise at least one said line of weakness that is parallel or substantially parallel to its most closely adjacent portion of the outer rim.

The opening may be circular. Slot portions of a bayonet coupling may be associated with the opening and engageable, upon a said power, switch or data module being inserted through the opening and rotated in the opening, by projecting portions of the bayonet coupling that project from the power, switch or data module. The bayonet coupling may be configured to mount the power, switch or data module relative to the flange in any one of a plurality of predetermined rotational orientations. The plurality of predetermined rotational orientations may comprise at least four equally spaced rotational orientations (e.g., first orientation, second orientation at 90 degrees to the first orientation, third orientation at 180 degrees to the first orientation, and fourth orientation at 270 degrees to the first orientation). A clip may be engageable between the power, switch or data module and the apparatus to lock the module and flange against relative rotation when the module is mounted to the flange. The flange may be secured to the module and one or more projection of the clip may engage a corresponding one or more recess of the apparatus to lock the module and flange against relative rotation when the module is mounted to the flange.

Each of at least some of the at least one line of weakness may be parallel or substantially parallel to its most closely adjacent portion of the outer rim. Each of a plurality of the at least one line of weakness may be perpendicular to each other and/or each of a plurality of the at least one line of weakness may be parallel to each other.

The flange may have a plurality of apertures extending therethrough and/or the operatively front face of the flange may be textured to facilitate retention of a render layer applied thereto.

The module may have a removable faceplate.

The assembly may comprise an inductive charging station. A primary coil of the inductive charging station may be located in the power, switch or data module or connected to the power, switch or data module. A magnet, such as a neodymium ring magnet, may be provided, for example in the apparatus or the module or a faceplate connected to the module, to magnetically retain a chargeable mobile device, such as a mobile phone, in a charging position over the inductive charging station.

The socket may be connected to the flange via the opening. The socket may be slidably engageable in the opening to facilitate adjustment of its insertion depth in the opening and may be releasably securable in the opening at the desired insertion depth. The desired insertion depth may include a depth at which an inlet end of the socket extends a first predetermined distance forwardly from the operatively front face of the flange. The first predetermined distance may be equal to a thickness of the substrate, such that, with the operatively front face of the flange in register with a said planar supporting surface on a rear of the substrate, the inlet end of the socket is flush with a front surface of the substrate. Instead or in addition, for example to configure the apparatus for use in embodiments in which the operatively rear surface of the flange is to be in register with a front surface of the substrate, the desired insertion depth may include a depth at which an inlet end of the socket extends a second predetermined distance rearwardly from the operatively front face of the flange.

Throughout this specification the word "comprise", or variations such as "comprises" or "comprising", will be understood to imply the inclusion of a stated element, integer or step, or group of elements, integers or steps, but not the exclusion of any other element, integer or step, or group of elements, integers or steps.

### Brief Description of Drawings

One or more embodiment of principles disclosed herein will now be described, by way of example only, with reference to the accompanying drawings, in which:
FIG. 1 is a first, front perspective view of a first embodiment of an apparatus for mounting a power, switch or data module;
FIG. 2 is a second, front perspective view of the apparatus of FIG. 1;
FIG. 3 is a first, rear perspective view of the apparatus of FIG. 1;
FIG. 4 is a second, rear perspective view of the apparatus of FIG. 1;
FIG. 5 is a side view of the apparatus of FIG. 1;
FIG. 6 is a first, front perspective view of a second embodiment of an apparatus for mounting a power, switch or data module;
FIG. 7 is a second, front perspective view of the apparatus of FIG. 6;
FIG. 8 is a first, rear perspective view of the apparatus of FIG. 6;
FIG. 9 is a second, rear perspective view of the apparatus of FIG. 6;
FIG. 10 is a side view of the apparatus of FIG. 6;
FIG. 11 is a cross sectional view of the apparatus of FIG. 6;
FIG. 12 is a first, front perspective view of an embodiment of a power module for mounting in the apparatus of FIGs. 1 to 5 or of FIGs. 6 to 11, the power module being shown with a standard faceplate connected thereto;

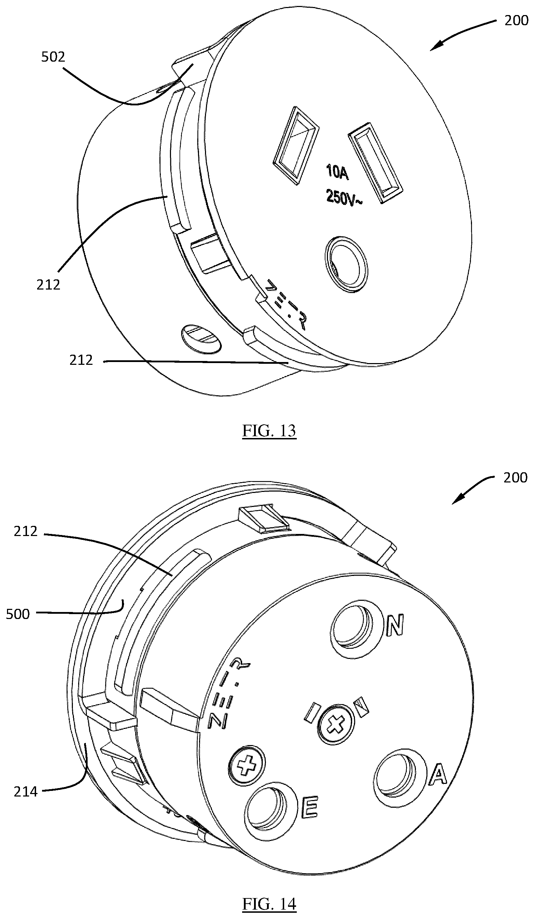

FIG. 13 is a second, front perspective view of the module of FIG. 12;
FIG. 14 is a first, rear perspective view of the apparatus of FIG. 12;

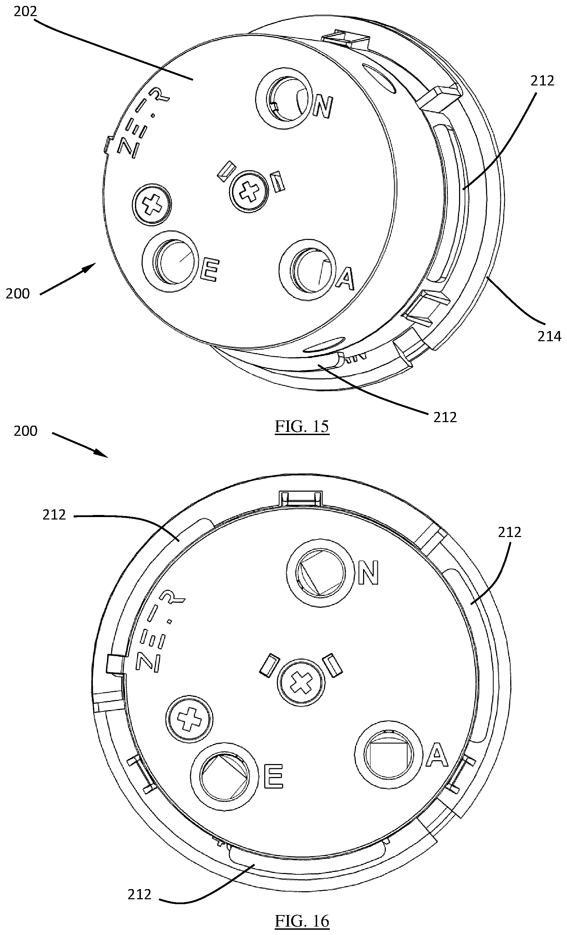

FIG. 15 is a second, rear perspective view of the apparatus of FIG. 12;
FIG. 16 is a rear view of the apparatus of FIG. 12;
FIG. 17 is a front perspective view of the apparatus of FIG. 12, shown with its faceplate removed;
FIG. 18 is a front perspective view of a magnetic retention faceplate for connection to the module of FIG. 12;
FIG. 19 is a rear perspective view of the magnetic retention faceplate of FIG. 18;
FIG. 20 is a front perspective view of an embodiment of an assembly comprising the apparatus of FIG. 1 and a variation of the power module of FIG. 12;
FIG. 21 is a schematic view showing the apparatus of FIG. 1 being installed on a substrate;
FIG. 22 is a front perspective view of an embodiment of an assembly comprising the apparatus of FIG. 6 and a switch module; and

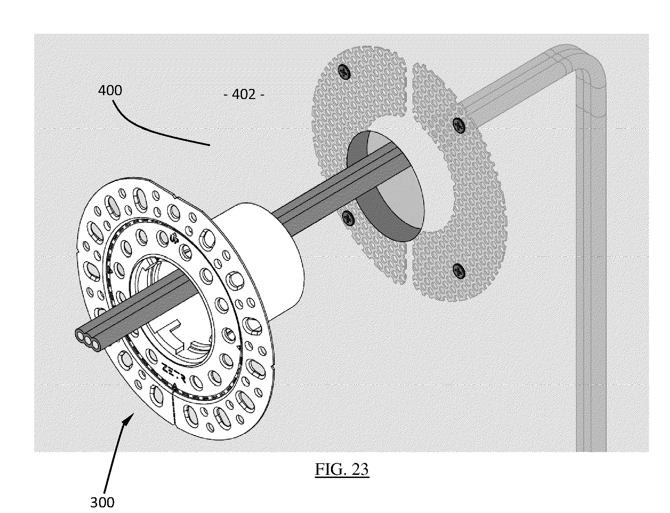

FIG. 23 is a schematic view showing the apparatus of FIG. 6 being installed on a substrate.

### Description of Embodiments

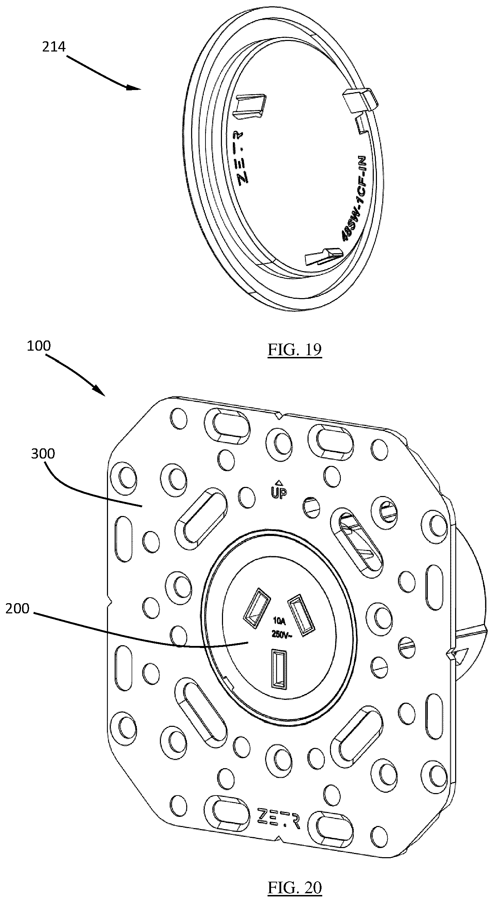

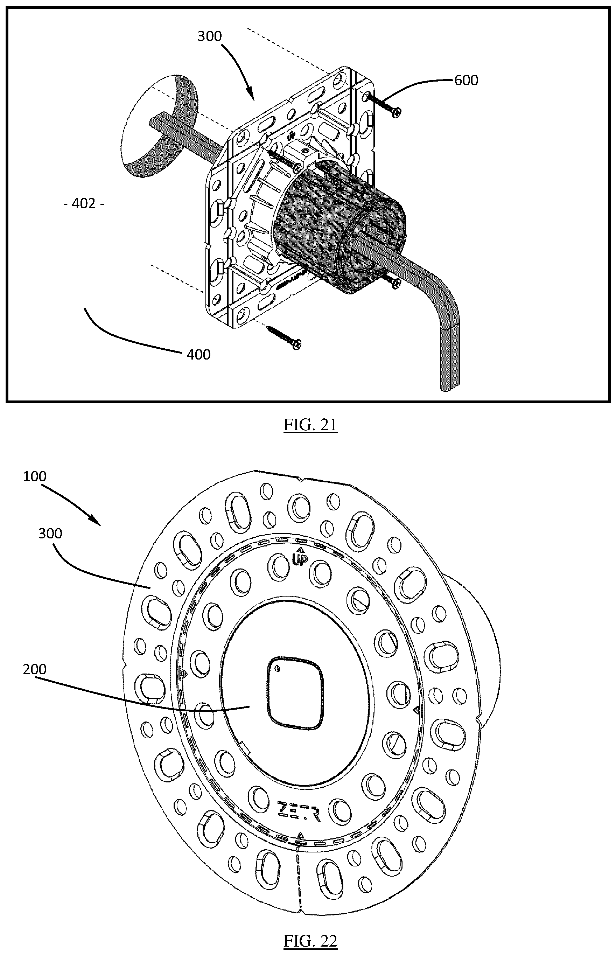

FIGs. 20 and 22, respectively, show a first embodiment and a second embodiment of an assembly 100. Both assemblies 100 comprise a power, switch or data module 200 and an apparatus 300 or 300' for mounting the power, switch or data module to a planar supporting surface 402 of a substrate 400.

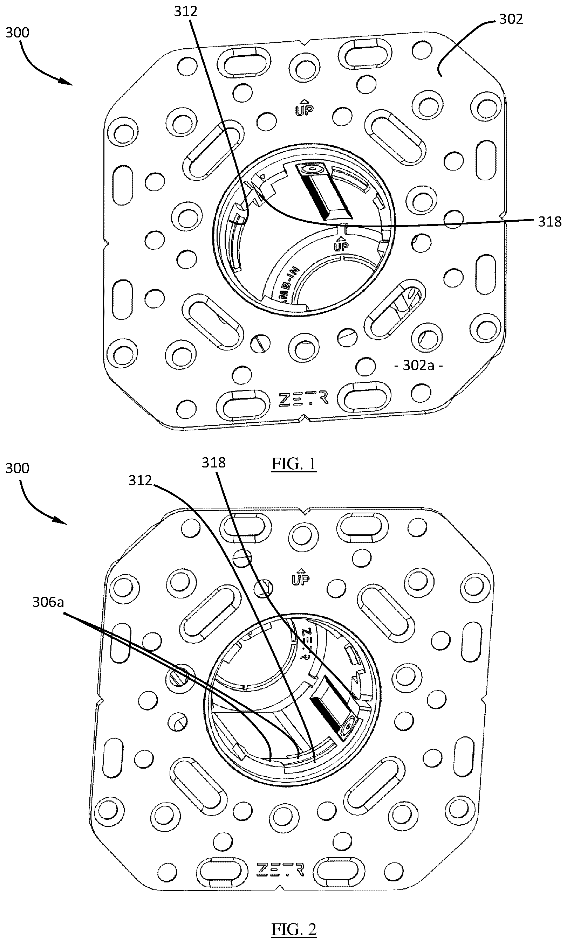

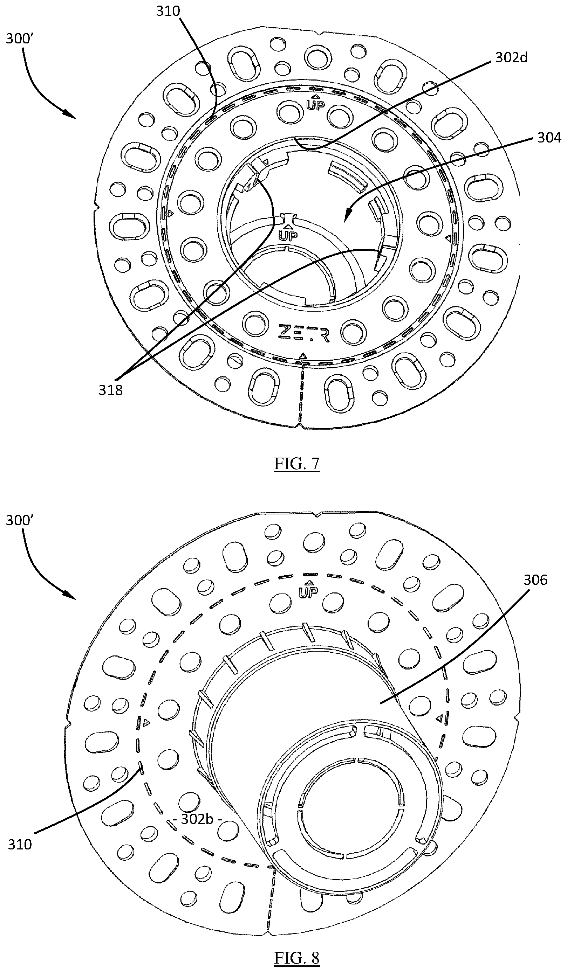

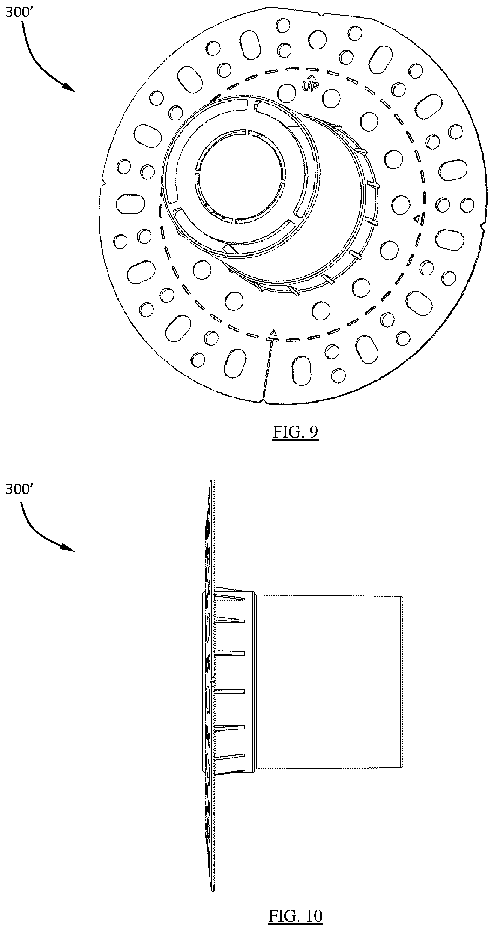

Referring to both FIGs. 1 to 5 and FIGs. 6 to 11, each of apparatus 300 and apparatus 300' comprises a flange 302 configured for abutment against and anchorage to the planar supporting surface 402. An operatively front face 302a of the flange 302 defines a first major surface of the flange, and has an outer periphery and an inner periphery. An operatively rear face 302b of the flange 302 defines a second major surface of the flange, and has an outer periphery and an inner periphery. An outer rim 302c of the flange extends between the outer periphery of the operatively front face 302a and the outer periphery of the operatively rear face 302b. An inner rim 302d of the flange 302 extends between the inner periphery of the operatively front face 302a and the inner periphery of the operatively rear face 302b, and defines an opening 304 extending through the flange. A mounting socket 306 for the power, switch or data module 200 is connected to the flange 302 in alignment with and extending rearwardly from the opening 304. The mounting socket 306 receives, via the opening 304, and mounts relative to the flange 302, the power, switch or data module 200. The flange 302 is reconfigurable via at least one line of weakness 308, 310 in the flange.

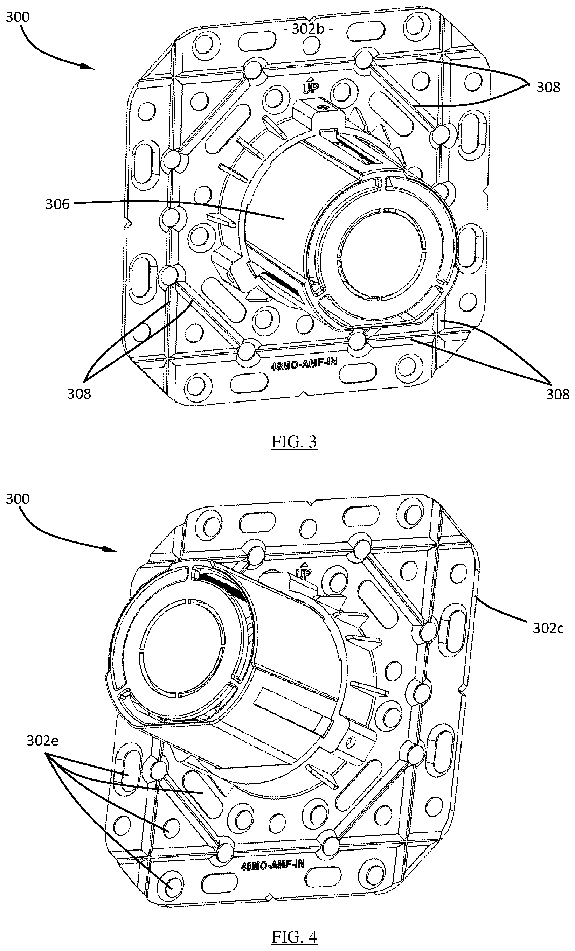

Apparatus 300 comprises a plurality of lines of weakness 308, each of the lines of weakness 308 defining fold lines along which the flange 302 is foldable to reorient a portion of the flange outboard of a line of weakness 308 along which the flange is folded relative to a portion of the flange inboard thereof. The lines of weakness 308 may be defined by the flange 302 being of reduced thickness along the lines of weakness 308, such as by the flange 302 having grooves therein that extend along the lines of weakness 308. As shown in FIGs. 3 and 4, the lines of weakness 308 comprise a first parallel pair on opposite sides of the opening 304, a second parallel pair on opposite sides of the opening and perpendicular to the first pair, a third parallel pair on opposite sides of the opening and at a non-perpendicular angle to both the first and second pairs, and a fourth parallel pair on opposite sides of the opening and perpendicular to the third pair. It will be appreciated that the lines of weakness 308 facilitate tessellation of the flange 302.

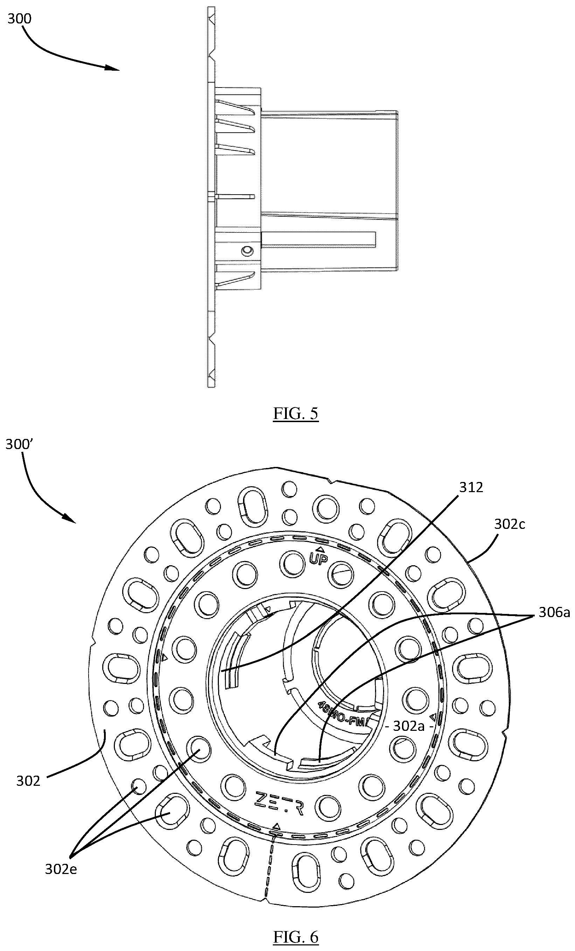

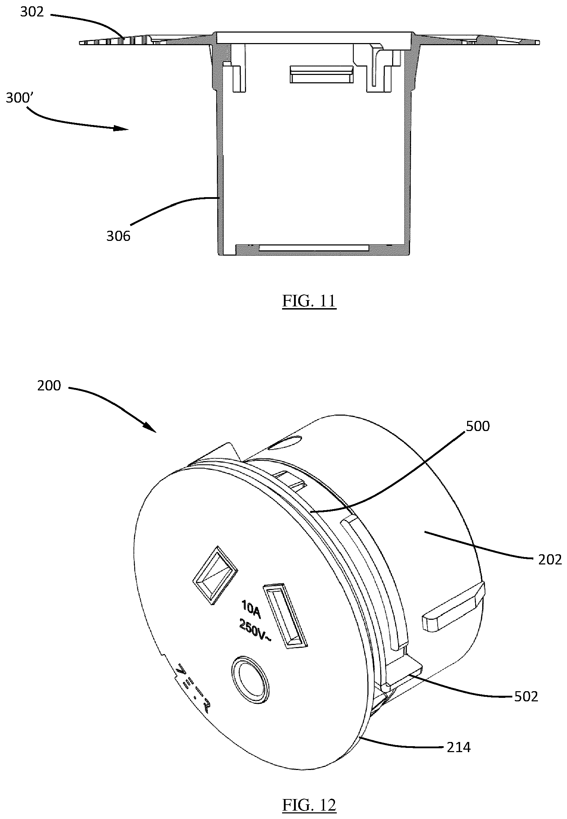

Apparatus 300' comprises a circular line of weakness 310 that facilitates removing an annuar portion of the flange 320 outboard thereof. For example, the flange 302 may be frangible or of reduced thickness along the line of weakness 310 to facilitate tearing or cutting of the flange therealong. With increasing distance from the opening 304, the flange 302 tapers in thickness toward the line of weakness 310, as shown in Fig. 11. As shown in FIGs. 6-9, the line of weakness 310 is parallel or substantially parallel to its most closely adjacent portion of the outer rim 302c.

The opening 304 is circular. Slot portions 312 of a bayonet coupling may be associated with the opening 304. In the illustrated embodiments, the slot portions 312 are defined by lands 306a on an inner surface of sidewalls of the socket 306. The slot portions 312 are engageable, upon a said power, switch or data module 200 being inserted through the opening 304 and rotated therein, by projecting portions 212 of the bayonet coupling that project from the power, switch or data module 200. The bayonet coupling may be configured to mount the power, switch or data module 200 relative to the flange 302 in any one of a plurality of predetermined rotational orientations. The plurality of predetermined rotational orientations may comprise at least four equally spaced rotational orientations (e.g., first orientation, second orientation at 90 degrees to the first orientation, third orientation at 180 degrees to the first orientation, and fourth orientation at 270 degrees to the first orientation). A clip 500 may be engageable between the power, switch or data module 200 and the apparatus 300 to lock the module and flange 302 against relative rotation when the module is secured to the flange via the bayonet coupling. For example, one or more projection 502 of the clip 500 may engage a corresponding one or more recess 318 of the apparatus 300 to lock the module 200 and flange 302 against relative rotation.

The flange 302 has a plurality of apertures 302e extending therethrough to receive threaded fasteners 600 for attaching the flange to the substrate 400. In embodiments in which the apparatus 300 or 300' is attached to the front surface of the substrate 400 with the operatively rear surface 302b of the flange 302 abutting the supporting surface 402, the apertures 302e may facilitate retention of a render layer applied over the flange 302. In some embodiments, the operatively front face 302a of the flange 302 may be textured to facilitate retention of a render layer applied over the flange.

The module 200 may have a faceplate 214 that is removably connectable to a body 202 of the module 200.

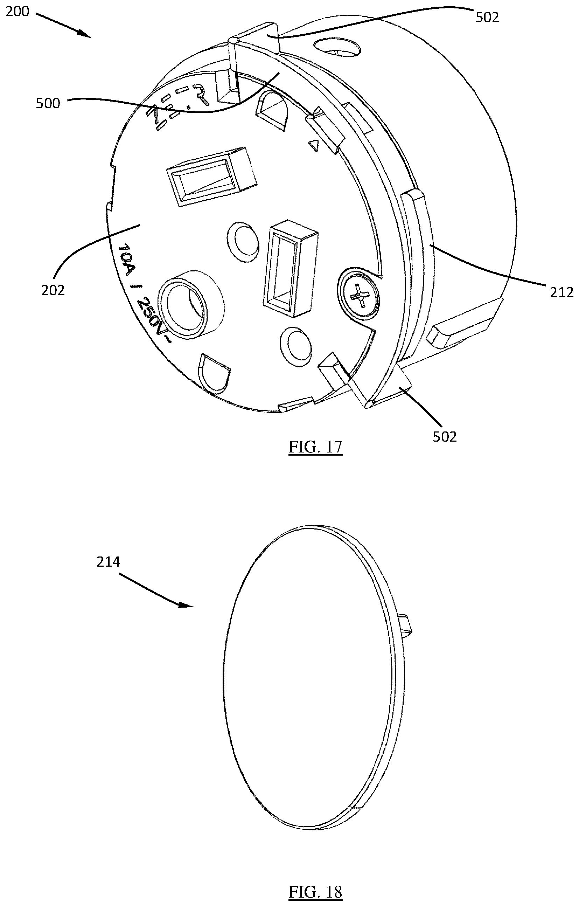

The assembly 100 may comprise an inductive charging station. A primary coil of the inductive charging station may be located in the power, switch or data module 200 or connected to the power, switch or data module 200. A magnet, such as a neodymium ring magnet, may be provided, for example in the apparatus 300, 300' or the module 200, or in a faceplate 214, such as that shown in FIGs. 18 and 19, connected to the module 200, to magnetically retain a chargeable mobile device, such as a mobile phone, in a charging position over the inductive charging station. The inductive charging station may be configured according to the Qi interface standard.

The socket 306 is connected to the flange 302 via the opening 304. In some embodiments, for example as shown in FIGs. 1-5, the socket 306 may be slidably engageable in the opening 304 to facilitate adjustment of its insertion depth in the opening and may be releasably securable in the opening at the desired insertion depth. For example, as shown in FIGs. 1-5, in order to facilitate the insertion depth of the socket in the opening being adjustable, the flange 302 and socket 306 of apparatus 300 may be connected to one another substantially in the same manner as are the mounting means 12' and holder 14' of the assembly 10' disclosed in the applicant's earlier Australian Patent Publication No. AU 2018203470 B2, the entire content of which is incorporated herein by way of reference. The desired insertion depth may include a depth at which an inlet end 306a of the socket 306 extends a first predetermined distance forwardly from the operatively front face of the flange. The first predetermined distance may be equal to a thickness of the substrate 400, such that, with the operatively front face 302a of the flange 302 in register with a planar supporting surface 402 defined by a rear of the substrate 400, the inlet end 306a of the socket 306 is flush with a front surface of the substrate. Instead or in addition, for example to configure the apparatus 300 for use in embodiments in which the operatively rear surface 302b of the flange 302 is to be in register with a front surface of the substrate 400, the desired insertion depth may include a depth at which an inlet end 306a of the socket 306 extends a second predetermined distance rearwardly from the operatively front face 302a of the flange 302.

It will be appreciated that the illustrated assembly 100 and apparatus 300, 300' provide numerous advantages. For example:
- The lines of weakness 308, 310 in the flange 302 facilitate the flange being reconfigured by removal of one or more outer portions of the flange and/or by reorientation of one or more portion of the flange relative to one or more other portion of the flange, thereby to facilitate easier. This reconfigurability of the flange 302 allows the assembly 100 and apparatus 300, 300' to be used in a wider array if circumstances, including by allowing tailoring of the configuration of the flange 302 to obstacles, such as elements of wall frames and plumbing behind the substrate 400, including, if desired, allowing the flange to be configured for connection to the side of such an obstacle.
- The lines of weakness 308, 310 in the flange 302 facilitate the footprint of the flange 302 being reduced, thereby facilitating a plurality of the apparatus 300, 300' being installed closer together, if desired.

It will be appreciated by persons skilled in the art that numerous variations and/or modifications may be made to the above-described embodiments, without departing from the broad general scope of the present disclosure. The present embodiments are, therefore, to be considered in all respects as illustrative and not restrictive. Examples of such variations and/or modifications include, but are not limited to features of the various embodiments of the apparatus 300, 300' being combined, and/or the module 200 being a combination power and data module.

## Claims

1. An apparatus for mounting a power, switch or data module, the apparatus comprising:
a flange configured for abutment against and anchorage to a planar supporting surface of a substrate, the flange having:
an operatively front face defining a first major surface of the flange, and having an outer periphery and an inner periphery,
an operatively rear face defining a second major surface of the flange, and having an outer periphery and an inner periphery,
an outer rim extending between the outer periphery of the operatively front face and the outer periphery of the operatively rear face, and
an inner rim extending between the inner periphery of the operatively front face and the inner periphery of the operatively rear face, the inner rim defining an opening extending through the flange,
the flange having connected thereto, or being configured to have connected thereto, a mounting socket for a power, switch or data module, the mounting socket, when connected to the flange, being aligned with and extending at least rearwardly from the opening to receive, and mount relative to the flange, a said power, switch or data module inserted through the opening,
wherein the flange is reconfigurable via at least one line of weakness in the flange.

2. The apparatus of claim 1, wherein the at least one line of weakness is configured to facilitate one or more of: removing a portion of the flange outboard of the at least one line of weakness; and folding of the flange about each of one or more fold line defined by a said line of weakness to reorient a portion of the flange outboard of the fold line relative to a portion of the flange inboard thereof.

3. The apparatus of claim 1, wherein at least one of the at least one line of weakness is frangible so as to facilitate tearing of the flange therealong, or of reduced thickness to facilitate cutting therealong, to facilitate removing a portion of the flange outboard of each of such at least one line of weakness, wherein, optionally, the at least one line of weakness configured to facilitate removing a portion of the flange outboard thereof comprises at least one said line of weakness that is parallel or substantially parallel to its most closely adjacent portion of the outer rim.

4. The apparatus of claim 3, wherein, with increasing distance from the opening, the flange tapers in thickness toward each said at least one line of weakness that is configured to facilitate removing the portion of the flange outboard thereof.

5. The apparatus of any one of the preceding claims, wherein at least some of the at least one line of weakness are defined by a reduced thickness portion of the flange so as to facilitate cutting or so as to define therealong a fold line as defined in claim 2, wherein, optionally, the apparatus comprises a plurality of said fold lines that are perpendicular to each other and/or a plurality thereof that are parallel to each other.

6. The apparatus of any one of the preceding claims, wherein:
the opening is circular; and
slot portions of a bayonet coupling are associated with the opening and engageable, upon a said power, switch or data module being inserted through the opening and rotated in the opening, by projecting portions of the bayonet coupling that project from the power, switch or data module,
wherein, optionally, the apparatus comprises a clip for engaging the power, switch or data module to lock the module and flange against relative rotation when the module is mounted to the flange.

7. The apparatus of claim 6, wherein the bayonet coupling is configured to mount the power, switch or data module relative to the flange in any one of a plurality of predetermined rotational orientations.

8. The apparatus of any one of the preceding claims, wherein the flange has a plurality of apertures extending therethrough for receiving fasteners for fastening the flange to the substrate.

9. The apparatus of any one of the preceding claims, wherein the socket is slidably engageable in the opening to facilitate adjustment of its insertion depth in the opening and is releasably securable in the opening at the desired insertion depth.

10. The apparatus of claim 9, wherein the socket is releasably securable in the opening at an insertion depth at which an inlet end of the socket extends a first predetermined distance forwardly from the operatively front face of the flange.

11. The apparatus of claim 9 or claim 10, wherein the first predetermined distance is equal to a thickness of the substrate, such that, with the operatively front face of the flange in register with a said planar supporting surface on a rear of the substrate, the inlet end of the socket is flush with a front surface of the substrate.

12. The apparatus of any one of claims 9 to 11, wherein the socket is releasably securable in the opening at an insertion depth at which an inlet end of the socket extends a second predetermined distance rearwardly from the operatively front face of the flange.

13. An assembly, comprising:
the power, switch or data module recited in claim 1; and
the apparatus of any one of the preceding claims,
the flange having connected thereto, or being configured to have connected thereto, the mounting socket for the power, switch or data module, the mounting socket, when connected to the flange, being aligned with and extending at least rearwardly from the opening to receive via the opening, and mount relative to the flange, the power, switch or data module.

14. The assembly of claim 13, comprising an inductive charging station having a primary coil located in or connected to the power, switch or data module.

15. The assembly of claim 14, comprising a magnet for magnetically retaining a chargeable mobile device in a charging position over the inductive charging station, wherein, optionally, the magnet is located in the apparatus or the module or a faceplate connected to the module.
